(19)

Europäisches Patentamt
European Patent Office
Office européen des brevets

(11) **EP 2 389 702 B1**

(12) **EUROPEAN PATENT SPECIFICATION**

(45) Date of publication and mention
of the grant of the patent:
**24.07.2013 Bulletin 2013/30**

(51) Int Cl.:
*G01R 31/02* *(2006.01)* *G01R 31/12* *(2006.01)*
*H01M 8/04* *(2006.01)* *G01R 27/18* *(2006.01)*
*G01R 27/02* *(2006.01)*

(21) Application number: **09807544.3**

(22) Date of filing: **22.12.2009**

(86) International application number:
**PCT/FI2009/051028**

(87) International publication number:
**WO 2010/084239 (29.07.2010 Gazette 2010/30)**

(54) **ARRANGEMENT AND METHOD FOR MONITORING GALVANIC ISOLATION OF FUEL CELL DEVICE**

ANORDNUNG UND VERFAHREN ZUR ÜBERWACHUNG DER GALVANISCHEN ISOLATION EINER BRENNSTOFFZELLENANORDNUNG

DISPOSITIF ET PROCÉDÉ DE CONTRÔLE DE L'ISOLATION GALVANIQUE D'UN DISPOSITIF DE PILE À COMBUSTIBLE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **23.01.2009 FI 20095053**

(43) Date of publication of application:
**30.11.2011 Bulletin 2011/48**

(73) Proprietor: **Convion Oy**
**02150 Espoo (FI)**

(72) Inventor: **ÅSTRÖM, Kim**
**FI-02460 Kirkkonummi (FI)**

(74) Representative: **LEITZINGER OY**
**Tammasaarenkatu 1**
**00180 Helsinki (FI)**

(56) References cited:
**EP-A1- 1 437 600        DE-C1- 19 503 749**
**US-A1- 2006 003 198**

Printed by Jouve, 75001 PARIS (FR)

## Description

### The field of the invention

Fuel cell devices are becoming general in fulfilling different kind of electricity production needs. Fuel cell devices are electrochemical devices supplied with reactants for producing electrical energy.

### The state of the art

Fuel cell devices are electrochemical devices, which enables production of electricity with high duty ratio in an environmentally friendly process. Fuel cell technology is considered as one of the most promising future energy production methods.

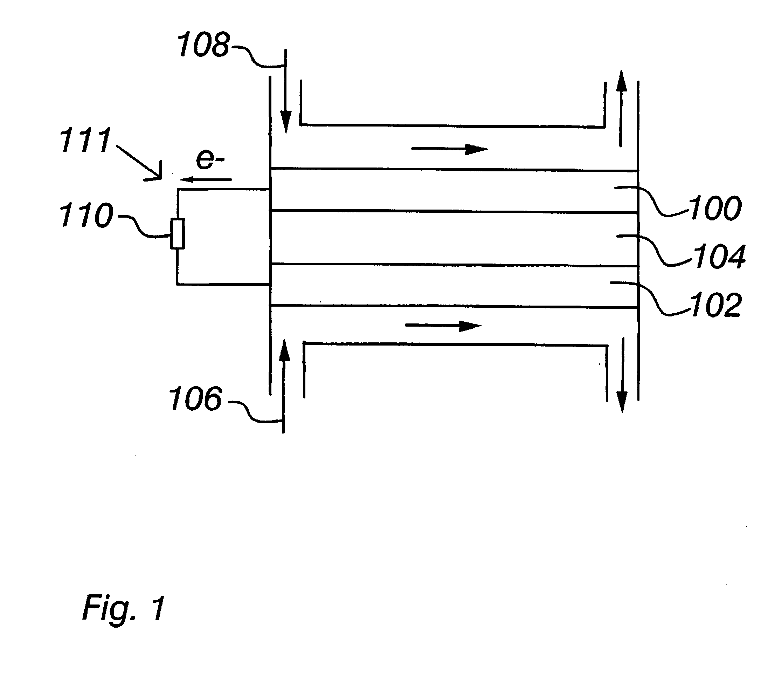

Fuel cell, as presented in fig 1, comprises an anode side 100 and a cathode side 102 and an electrolyte material 104 between them. The reactants fed to the fuel cell devices undergo a process in which electrical energy and heat are produced as a result of an exothermal reaction. For example in solid oxide fuel cells (SOFCs) oxygen 106 is fed to the cathode side 102 and it is reduced to a negative oxygen ion by receiving electrons from the cathode. The negative oxygen ion goes through the electrolyte material 104 to the anode side 100 where it reacts with the used fuel 108 producing water and also typically carbondioxide ($CO_2$). Between anode and cathode is an external electric circuit 111 as a load for fuel cell for transferring electrons e-to the cathode. External electric circuit comprises a load 110.

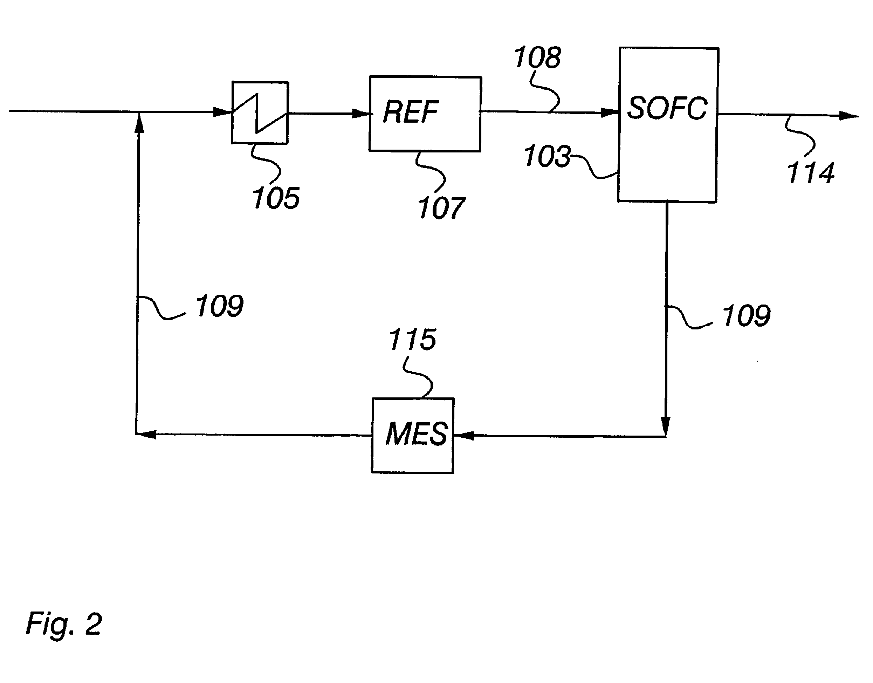

In figure 2 is presented a SOFC device as an example of fuel cell device, which can utilize as fuel for example natural gas, bio gas, methanol or other compounds containing hydrocarbons. SOFC device in figure 2 comprises planar-like fuel cells in stack formation 103 (SOFC stack). Each fuel cell comprises anode 100 and cathode 102 structure as presented in figure 1. Part of the used fuel is recirculated in feedback arrangement through each anode. SOFC device in fig 2 comprises a fuel heat exchanger 105 and a reformer 107. Heat exchangers are used for controlling thermal conditions in fuel cell process and there can be located more than one of them in different locations of SOFC device. The extra thermal energy in circulating gas is recovered in the heat exchanger 105 to be utilized in SOFC device or outside in a heat recovering unit. The heat recovering heat exchanger can thus locate in different locations as presented in figure 2. Reformer 107 is a device that converts the fuel such as for example natural gas to a composition suitable for fuel cells, for example to a composition containing half hydrogen and other half methane, carbondioxide and inert gases. The reformer is not, however, necessary in all fuel cell implementations, but untreated fuel may also be fed directly to the fuel cells 103.

By using measurement means 115 (such as fuel flow meter, current meter and temperature meter) is carried out necessary measurements for the operation of the SOFC device from the through anode recirculating gas. Only part of the fuel used at anodes 100 (figure 1) of the fuel cells 103 is recirculated through anodes in feedback arrangement 109 and thus in figure 2 is presented diagrammatically also as the other part of the gas is exhausted 114 from the anodes 100.

In fuel cell systems fuel cell stacks are most often grouped to serially and/or parallel connected groups. Voltage levels arising among fuel stacks have to isolated between fuel cell stacks to avoid unwanted current loops. Typically voltage levels have to be isolated also from installation structure of the fuel cell device, which comprises for example supporting structures, and piping, which includes for example fuel feed-in lines.

Adequate and stable electronic isolation is difficult to achieve in the case of demanding and chemically aggressive environments such as is the case with for example high temperature fuel cell applications. In these contexts corrosion, thermomechanical stress, material degradation or electrochemical phenomenon, which may caused by and/or accelerated by voltage differences of fuel cells, may each as individual phenomenon and together affecting cause conductive routes through the isolation and/or cause isolation breakdowns. Internally arising leakage currents among fuel cells degrade load power and may cause irreversible degradation to fuel cells, and even completely break the fuel cell stacks, which those leakage currents have had a possibility to heavily influence. These unpleasant effects are partially or totally avoided so that the galvanic isolation levels are continuously monitored and the lack of isolation is found early enough to leave time for necessary protective actions.

Deterioration of the isolation can not usually be easily detected in voltage and/or current measurements outside of the fuel cell device. If the fuel cell stacks are electrically unfloating, fault current measurement can be used to monitor leakage currents. Said method is however not proper to identify locations of leakage currents and said method is also not proper to observe leakage currents inside the fuel cell device.

Arrangements for the monitoring of galvanic isolation of fuel cell devices are disclosed in US 2008158736; JP 09274062; US 20070285102; US 2006003198.

**Short description of the invention**

The object of the invention is to monitor galvanic isolation in the fuel cell device so that deteriorations in isolation are detected so early that expensive and harmful consequences caused by breakdowns of isolation are successfully avoided. This is achieved by a measurement arrangement for monitoring galvanic isolation of a fuel cell device, which fuel cell device comprises at least one stack of fuel cells, at least one load circuit for fuel cells, and at least one structure near at least one said stack. The fuel cell device comprises as load circuit current processing means comprising power electronics for processing direct current (dc-current) produced by fuel cells, the fuel cell device comprises galvanic isolation for disposing said at least one stack of fuel cells and said at least one load circuit for fuel cells to an electrically freely floating configuration towards at least one structure, the measurement arrangement comprises at least one measurement element comprising known impedance in connection to said at least one structure, and means for performing measurements from the measurement element to form voltage information of floatage of fuel cells towards said structure, the fuel cell device comprises at least two switching points, and the measurement arrangement comprises at least two switches for switching the switching points to said measurement element, the measurement arrangement comprises for monitoring galvanic isolation at least one signal processor to control said switches in measurements, and to process said formed voltage information and at least voltage information between switching points to form resistance information and capacitance information of galvanic isolation, and the forming of capacitance information is based on the comparability between capacitance values and an exponential constant of voltage information curve, and said at least one signal processor for combining said resistance and capacitance information to form information on condition of galvanic isolation and information on possible alteration of said condition.

The focus of the invention is also a method for monitoring galvanic isolation of a fuel cell device. In the method is used current processing means as load circuit for fuel cells, said current processing means comprising power electronics for processing direct current (dc-current) produced by fuel cells, is arranged at least one stack of fuel cells and said at least one load circuit for fuel cells to an electrically freely floating configuration towards at least one structure near fuel cells, is performed a controlled switching via at least two switching points to at least one measurement element comprising known impedance in connection to said at least one structure, is performed measurements from the measurement element to form voltage information, is processed said formed voltage information and at least voltage information between switching points to form resistance information and capacitance information of galvanic isolation, and the forming of capacitance information is based on the comparability between capacitance values and an exponential constant of voltage information curve, and is combined said resistance and capacitance information to form information on condition of galvanic isolation and information on possible alteration of said condition.

The invention is based on that fuel cells and at least one load circuit for fuel cells are arranged to an electrically freely floating configuration towards at least one structure in the vicinity of fuel cells. By using switches is performed switchings to at least one measurement element, which has fixed impedance, ie impedance, which remains substantially same during the implementation of the invention. Said impedance is in galvanic connection to at least one structure in the vicinity of the fuel cells. Measurement information of floatage of fuel cells towards the structure is formed by performing measurements from the measurement element in the moments of different switchings during operation of the fuel cell device. Measurement information can be processed by calculation in different ways for solving for example locations and/or values of leakage currents transpiring in galvanic isolation of the fuel cell device. Measurement information can also be processed by calculation for forming information on capacitance values of galvanic isolation. The capacitance values comprises information on possible routes of spurious signals in galvanic isolation.

The invention has the advantage that information obtained from leakage currents in isolation and their location and also from possible flow paths of spurious signals can be utilized in preventing operation problems of fuel cell device caused by isolation defects for example by starting early enough preventive service works for the fuel cell device. Thanks to monitoring of galvanic isolation according to the invention, new isolation defects are detected immediately and is prevented said defects from getting worse, and thus is enabled to increase the number of serial connected fuel cell stacks. An implementation of the invention can be utilized in any fuel cell device, which comprises one or more of fuel cell stack(s) disposed in electrically free-floating configuration. In addition, the method of the invention can be implemented with inexpensive components with necessarily no need to make additional connections to the fuel cells. It is also substantially useful, that the implementation according to the invention allows measurements and hence the monitoring of galvanic isolation while fuel cells are loaded, without disrupting the loading power electronics.

Short description of figures

Figure 1     shows an implementation of a single fuel cell.

Figure 2    shows an implementation of a fuel cell device.

Figure 3    shows a measurement arrangement integrated to the fuel cell device according to the preferred embodiment of the invention.

Figure 4    shows monitoring of isolation resistance according to the invention, in which positive and negative outputs of fuel cell stacks are connected in turn to grounding potential and/or to potential of a structure in vicinity of the fuel cell stacks via a measuring resistor Rm.

Figure 5    shows an equivalent circuit for leakage currents, when the switch S1 is closed and the load is very isolated.

Figure 6    shows applying of Thevenin's theorem in formation of an equivalent circuit for two interfaces of outputs of voltage sources and resistors.

Detailed description of the invention

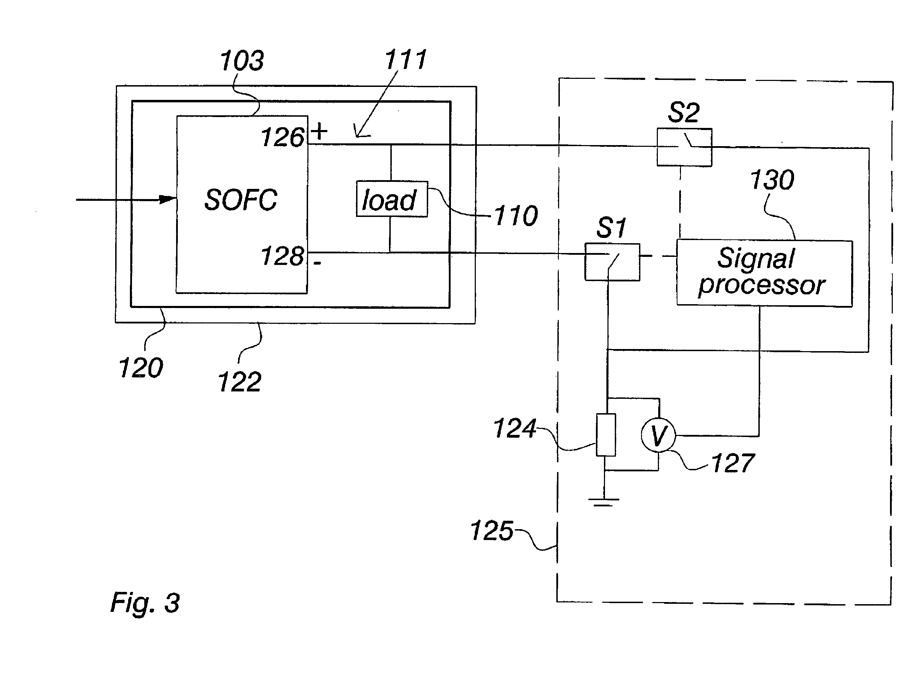

In fuel cell systems are generally required galvanic isolation between fuel cell stacks, and between the fuel cell stacks and at least one structure in the vicinity of the fuel cells. Said structure means for example a installation structure, which locates essentially around the fuel cell stacks. In other words, the structure 122 (Figure 3) means one or more installation structures in the vicinity of the fuel cell stacks, and other structure such as pipelines, from which fuel cell stacks need to be galvanically isolated. Adequate and stable electronic isolation is though difficult to achieve in the case of demanding and chemically aggressive environments such as is the case with for example high temperature fuel cell applications. Isolation breakdowns or reducing of isolation cause leakage currents, which reduce amount of electrical power available to the load, and can cause irreversible weakening of power to the fuel cell device and even breakdowns of fuel cell stacks, which have exposed to leakage currents. These negative effects are entirely avoidable, or at least in part avoidable, when quality of galvanic isolation is monitored during operation of the fuel cell device and decreased amount of isolation is detected early enough to start necessary security works.

In accordance to the invention is implemented a low cost implementation to continuously monitor galvanic isolation characteristics during operation of the fuel cell device. In the implementation according to the invention fuel cells and their loads are electrically floating in relation to the surrounding structures, such as grounding and/or installation structure, to which leakage currents are conducted. As a load 110 of fuel cells is as a loading electrical circuit 111 for fuel cells for example current processing means integrated in context with the fuel cell device, said means comprising power electronics for processing direct current (dc-current) produced by fuel cells.

In figure 3 is presented a measurement arrangement 125 for monitoring galvanic isolation 120 implemented in context with the fuel cell device according to the preferred embodiment of the invention. The fuel cell device usually comprises more than fuel cell stack 103, a installation structure 122, which locates substantially around the fuel cell stacks, and a loading electrical circuit 111 for fuel cells. The installation structure and other possible structures attached to it are preferanbly connected to protective potential. Galvanic isolation 120 is formed between fuel cell stacks 103 and installation structure 122 and if desired also between fuel cell stacks and piping 122 for disposing the fuel cell stacks and the loading electrical circuit 111 for fuel cells to an electronically freely floating configuration in relation to said installation structure and, if necessary, in relation to said piping. The loading electrical circuit for fuel cells according to the preferred embodiment of the invention comprises as the load 110 for example a DC power converter (DC-DC converter) for processing electricity produced by the fuel cells.

The measurement arrangement 125 implemented in context with the fuel cell device comprises at least one measurement element 124, which has a known impedance towards the installation structure 122. In the preferred embodiment of the invention as the measurement element 124 is used at least one measurement resistor, but the measurement element 124 can also be implemented with one or more capacitor(s) or coil(s), or with some combination of one or more resistor(s), capacitor(s) and/or coil(s). The measurement arrangement in accordance with the invention may also comprise measurement elements for forming different measurement areas, which have different impedances between each other towards the installation structure.

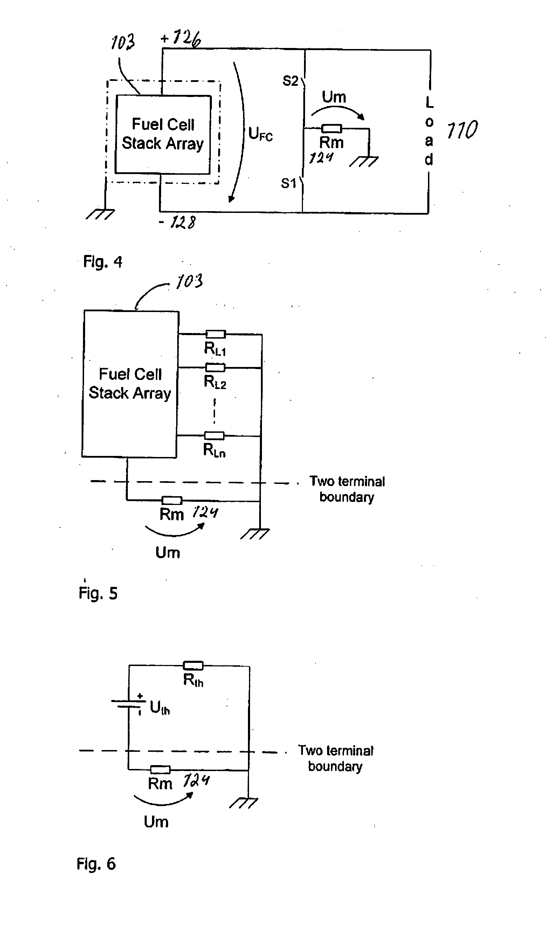

The fuel cell device comprises at least two output poles, ie switching points plus pole (+) 126 and minus pole (-) 128, to which connected the measurement arrangement comprises switches S1 and S2 for performing switchings via the switching points 126, 128 to the measurement resistor 124. Said switches are each preferably controlled in turn to open or closed conditions by using in the controlling a signal processor 130. The preferred embodiment of the invention comprises means 127 for measuring voltage of the measurement resistor for forming voltage information. Formed voltage information is processed by the signal processor 130 preferably so that they are compared to the reference voltage level for checking floatage of the fuel cell stacks 103 and the loading circuit 111 for the fuel cell stacks in relation to the installation structure. The implementation in accordance with the invention also requires a voltage information of fuel cell voltage (Ufc, figure 4), obtained by voltage measurements of voltage between switching points 126, 128, if said voltage information is not otherwise known.

On the basis of voltage information from different locations of isolation can be determined isolation resistance values in the processing of voltage information, said values reporting that leakage currents exists in said locations. In said voltage information processing can be used the same common signal processor 130, which is also used in control of switches S1, S2, or signal processors may also be separate. The signal processors may be by analogy, and/or digitally implemented micro controllers, signal processors, microprocessors, or other suitable implementations for the purpose. In the preferred embodiment of the invention as signal processing device 130 is used a digital device such as the signal processor.

In figure 4 is presented the isolation resistance monitoring in such a way that the positive and negative outputs 126, 128 of fuel cell stacks 103 are switched in turn to grounding potential and/or to potential of the installation structure via the measurement resistor Rm 124 to measure voltage (Um) over Rm. Switches S1 and S2 may be semi conductor components, such as transistor switches, or switch to other switch implementations. In the implementation according to the invention fuel cell stack voltage (Ufc) over one or more fuel cell stack is measured by means for measuring fuel cell voltage from the switch points 126 (+) and 128 (-); (accordingly Figure 3). It is also possible that the Ufc is a known voltage without measurements during the implementation of the invention, such as is the case for example in an embodiment in which the fuel cell device is connected to the battery, which voltage between its poles is known.

In figure 5 is presented an equivalent circuit for leakage currents, when the switch S1 is closed, provided that the load is very isolated, which is usually easily implemented. Leakage currents to potential of the installation structure surrounding the fuel cell stacks can occur from different voltage levels of fuel cell stacks, presented by resistors, ie recistances $R_{Ln}$ in Figure 5. In this case, fuel cell stacks and leakage resistances form a set of voltage sources and resistances. Said voltage sources can be considered as ideal compared to minor currents via the measurement resistor Rm 124, and leakage resistances can be considered to be linear.

Thus, Thevenin's theorem can be applied in accordance to figure 6 in formation of equivalent circuit to two interfaces of set of voltage sources and resistors. According to Thevenin's theorem every corresponding set, which has two outputs can be represented by a single voltage source $U_{th}$ and with a serial connected resistor $R_{th}$ in relation to $U_{th}$. Thevenin's theorem applies also when S1 is open and S2 closed, forming a corresponding equivalent circuit where the voltage source $U_{th}$ is replaced by the voltage source $U_{th}$-$U_{FC}$ when using the negative output of the set of fuel cell stacks 103 as zero voltage reference.

Indicating measured voltages $Um_1$ ja $Um_2$, measured when the switches S1 and S2 are in turn closed, the unknowns $U_{th}$ and $R_{th}$ of equation group can be solved:

$$R_{th} = R_m \left(U_{FC} + U_{m1} - U_{m2}\right) / \left(U_{m2} - U_{m1}\right)$$

$$U_{th} = -U_{m1} \left(U_{FC}\right) / \left(U_{m2} - U_{m1}\right)$$

$U_{th}$ corresponds to open circuit Thevenin voltage, which means in this embodiment according to the invention an inverted value of voltage of negative output for the set of fuel cell stacks, when external load is not exposed to the leakage circuit, ie switches S1 and S2 are open in figures 3 and 4, this meaning that measuring resistor Rm 124 have been removed. By applying Thevenin's theorem resistance $R_{th}$ corresponds to leakage resistance of parallel connected total resistance of all leakage resistances, ie $Rth = R_{11} \| R_{L2} \| ... \| R_{Ln}$. Thus, solved voltage $U_{th}$ gives an indication of location of isolation defect in relation to zero voltage reference, while $R_{th}$ represents the worst case internal leakage current among the fuel cells. Measurement procedure, such as alternate closing and opening of switches S1 and S2, do not affect operation of the isolated load, and thus measurement operation can be carried out continuously during operation of the fuel cell device. Because of configuration of floating stacks 103, a single connection to a chassis do not affect the fuel cells, but it is nevertheless observed with the measurement method according to the invention thus allowing, for example to cut off the operation of the fule cell device, before a destructive internal current loop arises among the fuel cell stacks. At such an early stage formed indication information on changes in isolation properties of the fule cell device can be utilized in preventive service works for fuel cell device at the right time.

In the implementation according to the invention is formed an electrical equivalent circuit to determine locations of leakage currents by grounding performed by one or more measurement element. The exponential chape of measurement curve is an indication of measured capacitance. The value of dielectric constant is affected by moisture, temperature, etc. factors. By more dense measuring of measurement values or by calculation the exponential shape of voltage information curve can be improved and the exponential constant can be found to be proportional to the capacitance. From measurement data can be observed that if the change in speed is slow at the time of switching, it indicates that a significant amount of capacitance exists. By the signal processor voltage information is calculated and can be determined change dynamics of voltage values related to switch condition changes, which can be utilized in forming of capacitance information.

Capacitance is a harmful phenomenon, because it indicates an alternation in isolation. Capacitance and resistance information, formed together and also separately, can be utilized in a complementary way in forming information on galvanic isolation and its alternations. Effective capacitance reflects the fact that from isolation can be found a path for spurious signals to move ahead. Resistance reflects the fact that leak current is occurring in isolation.

Accordance to the invention can thus be implemented an active method, which allows continuous monitoring of total isolation resistance and total capacitance of floating fuel stacks in the fuel cell device. Isolation resistance towards unfloating voltage of installation structure around the fuel cell stacks, ie towards voltage of installation structure of fuel cell stacks, is measured by means, which switches in sequences one of outputs of fuel cell stacks to the installation via the measurement element which has known impedance, by measuring voltage over said measurement element. Necessarily impedance value of the measurement element need not be exactly known, but important is that impedance remains substantially same during implementation of the invention. According to circuit theory can be determined total leakage resistance on the basis of measurements and information, provided by said measurements, on amount of leakages in different locations. Information obtained in this way can be utilized in preventing failures of fuel cell stacks caused by isolation defects as well as in preventive maintenance work for the fuel cell device.

The set of fuel cell stacks in methods according to the invention can be a single fuel cell stack or any size of set of fuel cell stacks. The fuel cell device may comprise one or more set of fuel cell stacks, and monitoring of isolation resistance and/or capacitance is arranged for one or more fuel cell stack(s) individually or together for all fuel cell stacks. Method according to the invention can be implemented so that the measurement arrangement is disposed on a separate device and/or integrated to power electronics of the fuel cell device, which can also be a load of the fuel cell device, thus allowing to keep the number of component and manufacturing costs in a minimum.

Although above is presented together with the figures utilization of implementations according to the invention in SOFC fuel cell devices, it should be noted, that implementations according to the invention can be utilized also in other kinds of fuel devices.

Although the invention has been presented in reference to the attached figures and specification, the invention is by no means limited to those as the invention is subject to variations within the scope allowed for by the claims.

## Claims

1.  A measurement arrangement (125) for monitoring galvanic isolation (120) of a fuel cell device, which fuel cell device comprises at least one stack (103) of fuel cells, at least one load circuit (111) for fuel cells, and at least one ground potential structure (122) connected to protective grounding near at least one said stack, **characterized by**, that

    - the fuel cell device comprises as load circuit (111) current processing means comprising power electronics for processing direct current (dc-current) produced by the fuel cells,
    - the fuel cell device comprises galvanic isolation (120) for disposing said at least one stack (103) of fuel cells and said at least one load circuit (111) for fuel cells to an electrically freely floating configuration towards the at least one ground potential structure (122),
    - the measurement arrangement comprises at least one measurement element (124) comprising known impedance in connection to said at least one ground potential structure (122), and means (127) for performing measurements from the measurement element to form voltage information of floatage of fuel cells towards said ground potential structure,
    - the fuel cell device comprises at least two switching points (126, 128), said switching points being in connection to voltage values of the fuel cells, and the measurement arrangement (125) comprises at least two switches (S1, S2) for switching the switching points (126, 128) to said measurement element (124),
    - and the measurement arrangement (125) comprises for monitoring galvanic isolation (120) at least one signal processor (130) to control said switches in measurements, and to process said formed voltage information and at least voltage information between switching points (126, 128) to form resistance information and capacitance information of galvanic isolation (120), and the forming of capacitance information is based on the comparability between capacitance values and an exponential constant of voltage information curve, and said at least one signal processor (130) for combining said resistance and capacitance information to form information on condition of galvanic isolation and information on possible alteration of said condition.

**2.** A fuel cell device in accordance with claim 1, **characterized by**, that the measurement arrangement (125) comprises measurement elements (124) for forming different measurement areas, said measurement elements (124) comprising different impedances between them (124).

**3.** A fuel cell device in accordance with claim 1, **characterized by**, that the measurement arrangement (125) comprises the signal processor (130) for processing voltage information by calculating estimations for change dynamics of voltage information related to switch condition changes of switches (S1, S2) in forming of capacitance information.

**4.** A fuel cell device in accordance with claim 1, **characterized by**, that the fuel cell device comprises the measurement arrangement (125), which has been integrated to control electronics of power electronics, which power electronics performs current processing of the fuel cell device.

**5.** A fuel cell device in accordance with claim 1, **characterized by**, that the fuel cell device comprises at least one DC-DC converter as load for the fuel cells.

**6.** A method for monitoring galvanic isolation (120) of a fuel cell device, in which method at least one ground potential structure (122) is connected to protective grounding, **characterized by**, that in the method

- is used current processing means as load circuit (111) for fuel cells, said current processing means comprising power electronics for processing direct current (dc-current) produced by fuel cells,
- is arranged at least one stack (103) of fuel cells and said at least one load circuit (111) for fuel cells to an electrically freely floating configuration towards said at least one ground potential structure (122) near fuel cells,
- is performed a controlled switching via at least two switching points (126, 128) to at least one measurement element (124) comprising known impedance in connection to said at least one ground potential structure (122), said switching points (126, 128) being in connection to voltage values of the fuel cells,
- is performed measurements from the measurement element to form voltage information,
- is processed said formed voltage information and at least voltage information between switching points (126, 128) to form resistance information and capacitance information of galvanic isolation (120), and the forming of capacitance information is based on the comparability between capacitance values and an exponential constant of voltage information curve, and is combined said resistance and capacitance information to form information on condition of galvanic isolation and information on possible alteration of said condition.

**7.** A method in accordance with claim 6, **characterized by**, that for forming different measurement areas is used measurement elements (124), said measurement elements (124) comprising different impedances between them (124).

**8.** A method in accordance with claim 6, **characterized by**, that for forming capacitance information voltage information is processed by calculating estimations for change dynamics of voltage information related to switch condition changes of switches (S1, S2).

**9.** A method in accordance with claim 6, **characterized by**, that dc-current produced by the fuel cells is processed by at least one DC-DC converter, which is as load for the fuel cells.

**Patentansprüche**

**1.** Messeinrichtung (125) zur Überwachung der galvanischen Isolation (120) einer Brennstoffzellenanordnung, wobei die Brennstoffzellenanordnung mindestens einen Stapel (103) von Brennstoffzellen, mindestens einen Lastkreis (111) für die Brennstoffzellen und mindestens eine Erdpotenzialstruktur (122) umfasst, die an die Schutzerde in der Nähe des mindestens einen Stapels angeschlossen ist, **dadurch gekennzeichnet, dass**

- die Brennstoffzellenanordnung Stromverarbeitungsmittel als Lastkreis (111) umfasst, die eine Leistungselektronik zum Verarbeiten von Gleichstrom (DC-Strom) aufweisen, der durch die Brennstoffzellen erzeugt wird,
- die Brennstoffzellenanordnung eine galvanische Isolation (120) aufweist, um den mindestens einen Stapel (103) von Brennstoffzellen und den mindestens einen Lastkreis (111) für die Brennstoffzellen in einer Konfiguration anzuordnen, die gegen die mindestens eine Erdpotenzialstruktur (122) elektrisch frei schwebt,
- die Messeinrichtung mindestens ein Messelement (124), das eine bekannte Impedanz in Verbindung mit der mindestens einen Erdpotenzialstruktur (122) aufweist, und Mittel (127) für das Ausführen von Messungen durch das Messelement umfasst, um Spannungsinformationen des Schwebens der Brennstoffzellen gegen die Erdpotenzialstruktur zu erzeugen,

- die Brennstoffzellenanordnung mindestens zwei Schaltpunkte (126, 128) umfasst, wobei die Schaltpunkte in Verbindung mit den Spannungswerten der Brennstoffzellen sind und die Messeinrichtung (125) mindestens zwei Schalter (S1, S2) für das Schalten der Schaltpunkte (126, 128) an das Messelement (124) umfasst,

- und die Messeinrichtung (125) mindestens einen Signalprozessor (130) zur Überwachung der galvanischen Isolation (120) umfasst, um die Schalter bei den Messungen zu steuern und um die erzeugten Spannungsinformationen sowie mindestens die Spannungsinformationen zwischen den Schaltpunkten (126, 128) zu verarbeiten, um Widerstandsinformationen und Kapazitätsinformationen der galvanischen Isolation (120) zu erzeugen, und wobei das Erzeugen der Kapazitätsinformationen auf der Vergleichbarkeit zwischen Kapazitätswerten und einer Exponentenkonstanten der Spannungsinformationskurve beruht, und wobei der mindestens eine Signalprozessor (130) die Widerstands- und Kapazitätsinformationen kombiniert, um Informationen über den Zustand der galvanischen Isolation und Informationen über eine mögliche Veränderung dieses Zustandes zu erzeugen.

2. Brennstoffzellenanordnung nach Anspruch 1, **dadurch gekennzeichnet, dass** die Messeinrichtung (125) Messelemente (124) zum Erzeugen unterschiedlicher Messbereiche umfasst, wobei die Messelemente (124) unterschiedliche Impedanzen zwischen ihnen (124) aufweisen.

3. Brennstoffzellenanordnung nach Anspruch 1, **dadurch gekennzeichnet, dass** die Messeinrichtung (125) den Signalprozessor (130) zum Verarbeiten der Spannungsinformationen durch Berechnen von Schätzungen für die Veränderungsdynamik der Spannungsinformationen umfasst, die auf die Schaltzustandsveränderungen der Schalter (S1, S2) bei der Erzeugung von Kapazitätsinformationen bezogen ist.

4. Brennstoffzellenanordnung nach Anspruch 1, **dadurch gekennzeichnet, dass** die Brennstoffzellenanordnung die Messeinrichtung (125) umfasst, die zum Steuern der Elektronik einer Leistungselektronik integriert ist, wobei die Leistungselektronik die Stromverarbeitung der Brennstoffzellenanordnung ausführt.

5. Brennstoffzellenanordnung nach Anspruch 1, **dadurch gekennzeichnet, dass** die Brennstoffzellenanordnung mindestens einen Gleichstromwandler als Last für die Brennstoffzellen umfasst.

6. Verfahren zur Überwachung der galvanischen Isolation (120) einer Brennstoffzellenanordnung, wobei in dem Verfahren mindestens eine Erdpotenzialstruktur (122) an die Schutzerde angeschlossen ist, **dadurch gekennzeichnet, dass** in dem Verfahren

- Stromverarbeitungsmittel als Lastkreis (111) für die Brennstoffzellen verwendet werden, wobei die Stromverarbeitungsmittel eine Leistungselektronik zum Verarbeiten von Gleichstrom (DC-Strom) umfassen, der durch die Brennstoffzellen erzeugt wird,

- mindestens ein Stapel (103) von Brennstoffzellen und der mindestens eine Lastkreis (111) für die Brennstoffzellen in der Nähe der Brennstoffzellen in einer Konfiguration eingerichtet ist, die gegen die mindestens eine Erdpotenzialstruktur (122) elektrisch frei schwebt,

- über mindestens zwei Schaltpunkte (126, 128) ein gesteuertes Schalten an mindestens einem Messelement (124) ausgeführt wird, das eine bekannte Impedanz in Verbindung mit der mindestens einen Erdpotenzialstruktur (122) aufweist, wobei die Schaltpunkte (126, 128) in Verbindung mit den Spannungswerten der Brennstoffzellen sind,

- von dem Messelement Messungen ausgeführt werden, um Spannungsinformationen zu erzeugen,

- die erzeugten Spannungsinformationen sowie mindestens die Spannungsinformationen zwischen den Schaltpunkten (126, 128) verarbeitet werden, um Widerstandsinformationen und Kapazitätsinformationen der galvanischen Isolation (120) zu erzeugen, und wobei das Erzeugen der Kapazitätsinformationen auf der Vergleichbarkeit zwischen Kapazitätswerten und einer Exponentenkonstanten der Spannungsinformationskurve beruht und die Widerstands- und Kapazitätsinformationen kombiniert werden, um Informationen über den Zustand der galvanischen Isolation und Informationen über eine mögliche Veränderung dieses Zustandes zu erzeugen.

7. Verfahren nach Anspruch 6, **dadurch gekennzeichnet, dass** Messelemente (124) zum Erzeugen unterschiedlicher Messbereiche verwendet werden, wobei die Messelemente (124) unterschiedliche Impedanzen zwischen ihnen (124) aufweisen.

8. Verfahren nach Anspruch 6, **dadurch gekennzeichnet, dass** zur Erzeugung von Kapazitätsinformationen die Spannungsinformationen durch Berechnen von Schätzungen für die Veränderungsdynamik der Spannungsinformationen verarbeitet werden, die auf die Schaltzustandsveränderungen der Schalter (S1, S2) bezogen ist.

9. Verfahren nach Anspruch 6, **dadurch gekennzeichnet, dass** der Gleichstrom, der durch die Brennstoffzellen erzeugt wird, durch mindestens einen Gleichstromwandler, der als Last für die Brennstoffzellen dient, verarbeitet wird.


## Revendications

1. Agencement de mesure (125) pour surveiller une isolation galvanique (120) d'un dispositif de pile à combustible, lequel dispositif de pile à combustible comprend au moins un empilement (103) de piles à combustible, au moins un circuit de charge (111) pour des piles à combustible, et au moins une structure de potentiel de masse (122) reliée à une masse de protection à proximité dudit au moins un empilement, **caractérisé en ce que** :

   - le dispositif de pile à combustible comprend, en tant que circuit de charge (111), un moyen de traitement de courant comprenant des composants électroniques de puissance pour traiter un courant continu (CC) produit par les piles à combustible,
   - le dispositif de pile à combustible comprend une isolation galvanique (120) pour disposer ledit au moins un empilement (103) de piles à combustible et ledit au moins un circuit de charge (111) pour des piles à combustible dans une configuration électriquement flottante libre vers l'au moins une structure de potentiel de masse (122),
   - l'agencement de mesure comprend au moins un élément de mesure (124) comprenant une impédance connue en liaison avec ladite au moins une structure de potentiel de masse (122), et un moyen (127) pour effectuer des mesures à partir de l'élément de mesure afin de constituer des informations de tension de flottement de piles à combustible vers ladite structure de potentiel de masse,
   - le dispositif de pile à combustible comprend au moins deux points de commutation (126, 128), lesdits points de commutation étant en liaison avec des valeurs de tension des piles à combustible, et l'agencement de mesure (125) comprend au moins deux commutateurs (S1, S2) pour commuter les points de commutation (126, 128) vers ledit élément de mesure (124),
   - et l'agencement de mesure (125) comprend, pour surveiller une isolation galvanique (120), au moins un processeur de signal (130) pour commander lesdits commutateurs dans des mesures, et pour traiter lesdites informations de tension constituées et au moins des informations de tension entre des points de commutation (126, 128) pour constituer des informations de résistance et des informations de capacité d'une isolation galvanique (120), et la constitution d'informations de capacité est basée sur la comparabilité entre des valeurs de capacité et une constante exponentielle d'une courbe d'informations de tension, et ledit au moins un processeur de signal (130) combine lesdites informations de résistance et de capacité pour constituer des informations sur l'état d'une isolation galvanique et des informations sur une altération éventuelle dudit état.

2. Dispositif de pile à combustible selon la revendication 1, **caractérisé en ce que** l'agencement de mesure (125) comprend des éléments de mesure (124) pour constituer différentes zones de mesure, lesdits éléments de mesure (124) comprenant différentes impédances entre eux (124).

3. Dispositif de pile à combustible selon la revendication 1, **caractérisé en ce que** l'agencement de mesure (125) comprend le processeur de signal (130) pour traiter des informations de tension en calculant des estimations de dynamique de changement d'informations de tension liées à des changements d'état de commutateur des commutateurs (S1, S2) afin de constituer des informations de capacité.

4. Dispositif de pile à combustible selon la revendication 1, **caractérisé en ce que** le dispositif de pile à combustible comprend l'agencement de mesure (125) qui est intégré à des composants électroniques de commande des composants électroniques de puissance, lesquels composants électroniques de puissance effectuant un traitement de courant du dispositif de pile à combustible.

5. Dispositif de pile à combustible selon la revendication 1, **caractérisé en ce que** le dispositif de pile à combustible comprend au moins un convertisseur CC-CC en tant que charge pour les piles à combustible.

6. Procédé destiné à surveiller une isolation galvanique (120) d'un dispositif de pile à combustible, dans lequel procédé au moins une structure de potentiel de masse (122) est reliée à une masse de protection, **caractérisé en ce que** le procédé :

- utilise un moyen de traitement de courant, en tant que circuit de charge (111) pour des piles à combustible, ledit moyen de traitement de courant comprenant des composants électroniques de puissance pour traiter un courant continu (CC) produit par des piles à combustible,

- est agencé sous la forme d'au moins un empilement (103) de piles à combustible et dudit au moins un circuit de charge (111) pour des piles à combustible dans une configuration électriquement flottante libre vers ladite au moins une structure de potentiel de masse (122) à proximité des piles à combustible,

- effectue une commutation commandée par l'intermédiaire d'au moins deux points de commutation (126, 128) sur au moins un élément de mesure (124) comprenant une impédance connue en liaison avec ladite au moins une structure de potentiel de masse (122), lesdits points de commutation (126, 128) étant en liaison avec des valeurs de tension des piles à combustible,

- effectue des mesures à partir de l'élément de mesure pour constituer des informations de tension,

- traite lesdites informations de tension constituées et au moins des informations de tension entre des points de commutation (126, 128) pour constituer des informations de résistance et des informations de capacité d'une isolation galvanique (120), et la constitution d'informations de capacité est basée sur la comparabilité entre des valeurs de capacité et une constante exponentielle d'une courbe d'informations de tension, et le procédé combine lesdites informations de résistance et de capacité pour constituer des informations sur l'état d'une isolation galvanique et des informations sur une altération éventuelle dudit état.

7. Procédé selon la revendication 6, **caractérisé en ce qu'**il comprend la constitution de différentes zones de mesure en utilisant des éléments de mesure (124), lesdits éléments de mesure (124) comprenant différentes impédances entre eux (124).

8. Procédé selon la revendication 6, **caractérisé en ce qu'**il comprend le traitement des informations de tension, pour constituer des informations de capacité, en calculant des estimations de dynamique de changement des informations de tension liées à des changements d'état de commutateur des commutateurs (S1, S2).

9. Procédé selon la revendication 6, **caractérisé en ce que** le courant continu produit par les piles à combustible est traité par au moins un convertisseur CC-CC en tant que charge pour les piles à combustible.

Fig. 1

Fig. 2

EP 2 389 702 B1

Fig. 3

EP 2 389 702 B1

Fig. 4

Fig. 5

Fig. 6

14

**EP 2 389 702 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008158736 A
- JP 09274062 B
- US 20070285102 A
- US 2006003198 A